# EUROPEAN PATENT SPECIFICATION

(11) **EP 1 795 964 B1**
(45) Date of publication and mention of the grant of the patent: **19.10.2011**
(21) Application number: 06256272.3
(22) Date of filing: 08.12.2006
(51) Int. Cl.: G03F 7/075

(54) **Photosensitive printing element having silica nanoparticles and method for preparing the printing element**
Lichtempfindliches Druckelement mit Kieselsäurenanopartikeln und Verfahren zur Herstellung des Druckelements
Elément d'impression photosensible comprenant des nanoparticules de silice et procédé de préparation de l'élément

(30) Priority: 08.12.2005 US 296902
(43) Date of publication of application: 13.06.2007
(73) Proprietor: E.I. DU PONT DE NEMOURS AND COMPANY, Wilmington, DE 19898 (US)
(72) Inventor: Lungu, Adrian, Old Bridge, NJ 08857 (US)
(74) Representative: Towler, Philip Dean

(56) References cited:
- EP-A2- 1 457 823
- WO-A1-97/12942
- WO-A1-03/079114
- JP-A- 11 060 235

## Description

### BACKGROUND OF THE INVENTION

### 1. Field of the Invention

This invention pertains to a photosensitive printing element and a method for preparing the printing element, and in particular to a photosensitive printing element having a photopolymerizable composition containing an additive and a method for treating the element to form a relief surface.

### 2. Description of Related Art

Flexographic printing plates are well known for use in printing surfaces which range from soft and easy to deform to relatively hard, such as packaging materials, e.g., cardboard, plastic films, aluminum foils, etc.. Flexographic printing plates can be prepared from photosensitive elements containing photopolymerizable compositions, such as those described in U.S. Patents 4,323,637 and 4,427,759. The photopolymerizable compositions generally comprise an elastomeric binder, at least one monomer and a photoinitiator. Photosensitive elements generally have a photopolymerizable layer interposed between a support and a coversheet or multilayer cover element. Upon imagewise exposure to actinic radiation, photopolymerization of the photopolymerizable layer occurs in the exposed areas, thereby curing and rendering insoluble the exposed areas of the layer. Conventionally, the element is treated with a suitable solution, e.g., solvent or aqueous-based washout, to remove the unexposed areas of the photopolymerizable layer leaving a printing relief which can be used for flexographic printing. However, developing systems that treat the element with a solution are time consuming since drying for an extended period (0.5 to 24 hours) is necessary to remove absorbed developer solution.

As an alternative to solution development, a "dry" thermal development process may be used which removes the unexposed areas without the subsequent time-consuming drying step. In a thermal development process, the photosensitive layer, which has been imagewise exposed to actinic radiation, is contacted with an absorbent material at a temperature sufficient to cause the composition in the unexposed portions of the photosensitive layer to soften or melt and flow into an absorbent material. See U.S. Patents 3,060,023 (Burg et al.); 3,264,103 (Cohen et al.); 5,015,556 (Martens); 5,175,072 (Martens); 5,215,859 (Martens); and 5,279,697 (Peterson et al.). The exposed portions of the photosensitive layer remain hard, that is do not soften or melt, at the softening temperature for the unexposed portions. The absorbent material collects the softened un-irradiated material and then is separated/removed from the photosensitive layer. The cycle of heating and contacting the photosensitive layer may need to be repeated several times in order to sufficiently remove the flowable composition from the un-irradiated areas and form a relief structure suitable for printing. After such processing, there remains a raised relief structure of irradiated, hardened composition that represents the irradiated image.

A problem sometimes arises with printing elements in a thermal treatment process for preparing printing plates in that clean-out of uncured portions is insufficient to form a relief suitable for quality printing of highlight dots and fine lines. Efforts to improve the clean out of these elements are counter to the desired performance of the system and plate. Increasing number of cycles of heating and contacting of the photosensitive layer is counter to maintaining the productivity of the thermal development system. Increasing the temperature to heat the photosensitive element and to cause the uncured portions of the layer to melt or flow more readily may be contrary to maintaining dimensional integrity of the element. Further, it is desirable to improve the efficiency of such thermal treatment process by reducing the number of cycles of heating and contacting in order to form suitable relief structure. The problem of insufficient clean out of uncured portions to form a relief with highlight dots and fines lines can also occur with solution washout printing elements. In this case efforts to improve clean out, such as wash out with rotary brushes, can be detrimental to the element since brushing action can alter or destroy fine features of the relief.

Regardless of whether the photosensitive element is treated thermally or with a suitable solution, such as a solvent or aqueous based solution, to form the printing relief, the current state-of-the-art flexographic printing plates may not perform as desired. In particular, the printing surface flexographic printing plates may wear too quickly or prematurely, and thus limit the number of impressions the plate can print with suitable image fidelity. Worn printing surface of the printing plate reproduces images with poor image fidelity. Additionally, the relief surface of the printing plate typically can include one or more areas of relief elements, so called halftone dots, the composite of which simulate the levels of gray associated with a continuous tone image when printed. These dot relief elements can be quite fine, such as highlight dots, and have a tendency to chip or break during impression relief printing. The presence of aggressive inks particularly can weaken dots and cause dots to chip. Resistance to wear and dot chipping are desirable features for flexographic printing plates in order to meet increasing demands for quality printing.

Chen et al. in U.S. Patent 4,369,246 disclose the addition of immiscible polymeric or nonpolymeric organic or inorganic fillers, such as organophilic silicas and silicas, to a photosensitive layer in an elastomeric printing relief element. Cushner et al. in U.S. Patents 5,798,202 and U.S. Patent No. 5,804,353; and Kannurpatti et al. in U.S. Patent 6,737,216 disclose processes for making a flexographic printing plate by laser engraving a reinforced elastomeric layer on a flexible support. The elastomeric layer can be reinforced mechanically by incorporating reinforcing agents, such as finely divided particulate material that includes silica, into the elastomeric layer.

U.S. Publication No. 2004/0146806 A1 by Roberts et al., published Jul. 29, 2004, describes photopolymerizable resin composition for use in making flexographic printing plates. The resin composition comprises a base polymer, a crosslinking agent, a photoinitiator, and a nanoparticle-sized filler. The particle size of the filler is less than 1000 nm, which is actually micron-sized particles. The filler can be present in the composition from 0.5 to 25% by weight and can include zinc oxide, titanium dioxide, clay, and silicon dioxide.

U.S. Publication No. 2005/0040562 A1 by Steinmann et al., published Feb. 24, 2005, describes a process for forming a three-dimensional article by stereolithography and using a liquid radiation-curable composition containing a free-radical polymerizable organic substance, a photoinitiator, a cationic polymerizable photoinitiator, and at least one filler of silica-type nanoparticles suspended in the composition. A thin layer of the liquid composition is exposed imagewise to create the article. The silica nanoparticles are surface-modified and presuspended in an epoxy resin or (meth)acrylate resin. The amount of the nanoparticles in the liquid composition is between 15 to 60% by weight of the composition.

However, the presence of silica filler in photosensitive printing elements may not provide the desired improvement in wear resistance or dot chipping resistance, nor assure that the printing element will withstand the rigors of washout treatment or thermal treatment. Further, adding micron sized silica as particulate to the photopolymerizable layer tends to reduce the penetration of the ultraviolet radiation required to photochemically polymerize the element.

### SUMMARY OF THE INVENTION

It is an object of the present invention to provide a photosensitive printing element that can withstand rigorous conditions of treatment, including thermal treatment or solution treatment, to readily remove uncured portions of the element and provide a relief suitable for quality printing of fine features such as highlight dots and fine lines.

It is another object of the present invention to provide a photosensitive printing element that resists wear of the relief surface and chipping of the dot relief elements that can occur from the printing process.

It is yet another object of the present invention to provide a photosensitive printing element in which uncured portions of a photopolymerizable layer are efficiently removed by thermal treatment. That is, the relief structure is formed in fewer cycles of heating and contacting than thermally treated photosensitive printing elements of the prior art.

In accordance with this invention there is provided a photosensitive printing element comprising a layer of a photopolymerizable composition comprising an elastomeric binder, a photoinitiator, and a monomer comprising silica particles bonded with an organic material capable of crosslinking with the elastomeric binder.

In accordance with another aspect of this invention there is provided a process for preparing a flexographic printing form comprising providing a photosensitive printing element comprising a layer of a photopolymerizable composition comprising an elastomeric binder, a photoinitiator, and a monomer comprising silica particles bonded with an organic material capable of crosslinking with the elastomeric binder; imagewise exposing the photopolymerizable layer to actinic radiation forming polymerized portions and unpolymerized portions in the layer; and treating the element to remove the unpolymerized portions and form a relief surface suitable for printing.

### DESCRIPTION OF THE PREFERRED EMBODIMENTS

The present invention concerns a photosensitive printing element and a process of using the photosensitive element to make a flexographic printing plate. The photosensitive element is a photopolymerizable printing element having a layer of a photopolymerizable composition that includes an elastomeric binder, a photoinitiator, and a monomer comprising silica particles. In particular, the photosensitive element is a photopolymerizable printing element wherein the photopolymerizable layer includes an elastomeric binder, a photoinitiator, and a monomer comprising silica nanoparticles bonded with an organic material capable of crosslinking with the elastomeric binder. The silica particles may also be referred to herein as silicon dioxide, silicon dioxide particles, silica, silica nanoparticles, or silicon dioxide nanoparticles.

The photosensitive printing element of the present invention has several advantages. The presence of the monomer with silica nanoparticles in the photopolymerizable layer provides significant improvement in the mechanical properties of the photosensitive element over the use of conventional silica particles. The photosensitive printing element can withstand the rigorous conditions of associated with treatment to form a relief surface suitable for high quality printing of fine features such as lines and highlight dots of the resulting printing form. Also the photosensitive printing element resists wear of the relief surface and dot chipping of relief elements in the relief surface. Surprisingly and most unexpectedly, photosensitive printing elements of this invention form suitable relief surface during thermal development in fewer cycles of heating the element and contacting the element with a development medium, than thermally developed photosensitive elements of the prior art.

The photosensitive printing element includes at least one layer of a photopolymerizable composition. As used herein, the term "photopolymerizable" is intended to encompass systems that are photopolymerizable, photocrosslinkable, or both. In cases where the composition layer comprises more than one photopolymerizable layer on the substrate, the composition of each of the photopolymerizable layers can be the same or different from any of the other photopolymerizable layers. The photopolymerizable layer is a solid elastomeric layer formed of the composition comprising an elastomeric binder, a photoinitiator, and a monomer comprising silica particles bonded with an organic material capable of crosslinking with the elastomeric binder. The photoinitiator has sensitivity to actinic radiation. Throughout this specification actinic radiation will include ultraviolet radiation and/or visible light. The solid layer of the photopolymerizable composition is treated with one or more solutions and/or heat to form a relief suitable for flexographic printing. As used herein, the term "solid" refers to the physical state of the layer that has a definite volume and shape and resists forces that tend to alter its volume or shape. The layer of the photopolymerizable composition is solid at room temperature, which is a temperature between about 5° C and about 30°C. A solid layer of the photopolymerizable composition may be polymerized (photohardened), or unpolymerized, or both.

Unless otherwise indicated, the terms "photosensitive printing element" and "flexographic printing plate or form" encompasses elements or structures in any form suitable for flexographic printing, including, but not limited to, flat sheets, plates, seamless continuous forms, cylindrical forms, plates-on-sleeves, and plates-on-carriers.

The elastomeric binder can be a single elastomeric polymer or a mixture of two or more elastomeric polymers. The elastomeric binder can be a preformed polymer that serves as a matrix for the monomer and photoinitiator prior to exposure and is a contributor to the physical properties of the photopolymer both before and after exposure. The elastomeric binder includes one or more groups, such as vinyl groups, that can crosslink with the organic material on the silica nanoparticles. A nonlimiting example of the elastomeric binder is an A-B-A type block copolymer, where A represents a nonelastomeric block, preferably a vinyl polymer and most preferably polystyrene, and B represents an elastomeric block, preferably polybutadiene or polyisoprene. Preferred elastomeric binders are poly(styrenersoprene/styrene) block copolymers (SIS), poly(styrene/butadiene/styrene) block copolymers (SBS), and combinations of poly(styrene/isoprene/styrene) block copolymers and poly(styrene/butadiene/styrene) block copolymers. Also included are other tri-block copolymers, such as polystyrene-poly(ethylenebutylene)-polystyrene (SEBS), and multiblock copolymers containing one or more nonelastomeric blocks and one or more elastomeric blocks. The block copolymer can have any shape including linear, radial, and star shapes. The non-elastomer to elastomer ratio of the A-B-A type block copolymers is preferably in the range of from 10:90 to 35:65. Additional examples of elastomeric materials are described in Plastic Technology Handbook, Chandler et al., Ed., (1987).

The elastomeric binder may also be a thermoplastic elastomeric binder. When a layer containing a thermoplastic elastomeric binder is reinforced photochemically, the layer remains elastomeric but is no longer thermoplastic after such reinforcement. This includes, but is not limited to, copolymers of butadiene and styrene, copolymers of isoprene and styrene, and the above mentioned A-B-A tri-block copolymers. Additional examples of suitable binders include natural or synthetic polymers of conjugated diolefin hydrocarbons, including polyisoprene, 1,2-polybutadiene, 1,4-polybutadiene, butadiene/acrylonitrile.

The elastomeric binder also encompasses core shell microgels and blends of microgels and preformed macromolecular polymers, such as those disclosed in Fryd et al., U.S. Patent 4,956,252; Quinn et al., U.S. Patent 5,707,773; and Suzuki et al., U.S. Patents 5,679,485 and 5,830,621.

The elastomeric binder can also include a combination of materials provided that the resulting element has characteristics suitable for flexographic printing, which include flexibility, resilience, Shore A hardness, ink compatibility, ozone resistance, durability, and resolution. One embodiment of a multi-component system includes an elastomeric polyurethane composition. An example of a suitable polyurethane elastomer is the reaction product of (i) an organic diisocyanate, (ii) at least one chain extending agent having at least two free hydrogen groups capable of polymerizing with isocyanate groups and having at least one ethylenically unsaturated addition polymerizable group per molecule, and (iii) an organic polyol with a minimum molecular weight of 500 and at least two free hydrogen containing groups capable of polymerizing with isocyanate groups. For a description of some of these materials see U.S. Pat. Nos. 5,015,556 and 5,175, 072.

The elastomeric binder can be soluble, swellable, or dispersible in aqueous, semi-aqueous, water, or organic solvent washout solutions. Elastomeric binders which can be removed by treating in aqueous or semi-aqueous developers have been disclosed by Proskow, in U.S. Patent 4,177,074; Proskow in U.S. Patent 4,431,723; Worns in U.S. Patent 4,517,279; Suzuki et al. in U.S. 5,679,485 and U.S. 5,830,621; and Sakurai et al. in U.S. 5,863,704. The block copolymers discussed in Chen, U.S. Patent 4,323,636; Heinz et al., U.S. Patent 4,430,417; and Toda et al., U.S. Patent 4,045,231 can be treated by wash out in organic solvent solutions. Generally, the binders that are suitable for washout development are also suitable for thermal treatment wherein the unpolymerized areas of the photopolymerizable layer soften, melt, or flow upon heating.

The elastomeric binder is present from 40 to 80%, preferably 45 to 75%, and more preferably 45 to 65%, by weight based on the weight of the photosensitive composition.

The photoinitiator can be any single compound or combination of compounds which is sensitive to actinic radiation, generating free radicals which initiate the polymerization of the monomer or monomers without excessive termination. Any of the known classes of photoinitiators, particularly free radical photoinitiators such as quinones, benzophenones, benzoin ethers, aryl ketones, peroxides, biimidazoles, benzyl dimethyl ketal, hydroxyl alkyl phenyl acetophenone, dialkoxy acetophenone, trimethylbenzoyl phosphine oxide derivatives, aminoketones, benzoyl cyclohexanol, methyl thio phenyl morpholino ketones, morpholino phenyl amino ketones, alpha halogennoacetophenones, oxysulfonyl ketones, sulfonyl ketones, oxysulfonyl ketones, benzoyl oxime esters, thioxanthrones, comphorquinones, ketocoumarins, and Michler's ketone may be used. Alternatively, the photoinitiator may be a mixture of compounds in which one of the compounds provides the free radicals when caused to do so by a sensitizer activated by radiation, a so called photoinitiator system. Preferably, the photoinitiator for the main exposure (as well as post-exposure and backflash) is sensitive to visible or ultraviolet radiation, between 310 to 400 nm, and preferably 345 to 365 nm.

A second photoinitiator sensitive to radiation between 220 to 300 nm, preferably 245 to 265 nm, may optionally be present in the photopolymerizable composition. After treating, a plate can be finished with radiation between 220 to 300 nm to detackify the relief surfaces. The second photoinitiator decreases the finishing exposure time necessary to detackify the plate. Photoinitiators are generally present in amounts from 0.001 % to 10.0% based on the weight of the photopolymerizable composition.

The photopolymerizable composition contains at least one monomer comprising silica particles bonded with an organic material that is capable of crosslinking with the elastomeric binder. The presence of the organic material that is present on the silica particles causes the silica particles to participate in the photopolymerization reaction, particularly by crosslinking with the elastomeric binder, and thereby enhancing the mechanical strength of the printing element. (The organic material on the silica particles may also crosslink with the reactive group/s in the monomer.) Crosslinking is an attachment of two chains of polymer molecules by bridges composed of an element, a group, or a compound, which in this case is the organic material on the silica particles, to join certain carbon atoms of the chains. The at least one monomer, which is an ethylenically unsaturated compound with at least one terminal ethylenic group, is capable of addition polymerization. The at least one monomer with silica nanoparticles is compatible with the binder to the extent that a clear, non-cloudy photosensitive layer is produced. The at least one monomer is not particularly limited, and in particular includes acrylate monoesters of alcohols and polyols; acrylate polyesters of alcohols and polyols; methacrylate monoesters of alcohols and polyols; methacrylate polyesters of alcohols and polyols; and combinations thereof. Alcohols and polyols include, for example, alkanols; alkylene glycols; trimethylol propane; ethoxylated trimethylol propane; pentaerythritol; dipentaerythritol; polyacrylol oligomers; and the like. If a polyacrylol oligomer is used, the oligomer should preferably have a molecular weight greater than 1000. A mixture of monofunctional and multifunctional acrylates or methacrylates may be used. Monomers suitable for use include, but is not limited to, hexanediol diacrylate; hexanediol dimethacrylate; ethylene glycol diacrylate; ethylene glycol dimethacrylate; diethylene glycol diacrylate; and trimethylol propane triacrylate. Acrylated oligomers and methacrylated oligomers are also suitable. Additionally, the monomer can include acrylate and methacrylate derivatives of isocyanates, esters, epoxides and the like. Also suitable for use as the monomer are oligomers of urethane-acrylates and polyester-acrylates.

As the silica particles, any type of silica-type (or silicon dioxide-type) can be employed in the present invention, provided that the particles can be surface modified with an organic material capable of crosslinking with the elastomeric binder. The silica particles are nanometer (10⁻⁹) sized particles of silicon dioxide or silica that have an average diameter of about 20 nm and a very narrow particle size distribution (of diameter) about 5 to about 50 nm, preferably about 5 to 40 nm, and most preferably 18 to 22 nm. The nanometer sized silica particles offers a particular advantage over conventional micron sized silica particles in that the nanometer particles are so small that they do not reduce the penetration or scatter the actinic radiation that exposes the element. Preferably the particles are spherical. The silica particles are suspended homogeneously in the monomer, and do not agglomerate therein. The silica particles and the monomer form a colloidal dispersion of amorphous silicon dioxide in the monomer. The fraction of the disperse phase of particles can be between 10 and 80% by weight, preferably from 20 to 70% by.weight, and more preferably from 30 to 60% by weight, based on to total weight of the dispersion (i.e., disperse phase and flowable phase). (The flowable phase contains the polymerizable monomers, including oligomers.)

The silica nanoparticles may be made by any suitable method. Examples of such methods are described in "Reinforcing Nanoparticles in Reactive Resins"; T. Adebahr, C. Roscher, and J. Adam; an European Coating Journal, April 2001; and by Adam in US Publication No. 2004/0147029 A1 (published Jul. 29, 2004). The entirety of US Publication No. 2004/0147029 A1 is herein incorporated by reference. The silica particles are surface modified with the organic material capable of crosslinking with the elastomeric binder. Examples of the organic material, include organic compounds containing vinyl groups, or groups that can react under radical polymerization. Any method can be used to modify the surface of the silica particles to include the organic material. The organic material can be held to the outer surface of the silica particles by any forces, including but not limited to, bonding, coating, adhering, or absorbing to the outer surface the silica particles. It is preferred that the nanoparticles are produced from aqueous sodium silicate solution in a mild sol-gel chemical process so that a binding agent, such as unsaturated (meth)acrylic monomers and oligomers, is not damaged.

Preferred products suitable for use as the monomer comprising silica particles bonded with the organic material capable of crosslinking with the elastomeric binder are commercially available from Hanse Chemie of Geesthacht, Germany, under the trademark Nanocryl® nanocomposites. The nanocomposite includes the silica nanoparticles homogeneously dispersed in a flowable phase which includes one or more of acrylate monomers, acrylate oligomers, methacrylate monomers, and methacrylate oligomers. Any of the Nanocryl® product line may be suitable for use, including Nanocryt® A type series, Nanocryl® C type series, Nanocryl® D type series, and Nanocryl® P type series. Particularly preferred is the Nanocryl® C type series, including Nanocryl® C 350 (hydroxyethylmethacrylate containing 50% by weight silica nanoparticles); Nanocryl® C 140 (hexanedioldiacrylate containing 50% by weight silica nanoparticles); Nanocryl® C 150 ( trimethylol propane triacrylate containing 50% by weight silica nanoparticles).

The monomer with silica nanoparticles bonded with the organic material that is capable of crosslinking with the elastomeric binder is present in the photopolymerizable composition in amounts from 1 to 50% by weight, preferably 3 to 30% by weight, and most preferably 5 to 15% by weight, based on the total weight of the photopolymerizable composition. The photopolymerizable composition may include one or more of the monomer with silica nanoparticles bonded with the organic material. The silica nanoparticles in the photopolymerizable composition, i.e., the loading of silica particles, is present in amount from 0.1 to 30%, preferably 5 to 20%, and most preferably 8 to 15% by weight based on the total weight of the photopolymerizable composition. The degree of loading of the silica nanoparticles in the photopolymerizable composition basically determines the improvement in wear resistance and in withstanding rigorous treatment conditions that will be exhibited by the printing form. Since the monomer can include the silica nanoparticles from 10 to 80% by weight of the dispersion, and the photopolymerizable composition may also include one or more optional monomers (without silica particles), the amount of monomer with silica particles is selected in order to provide the desired degree of loading of the silica nanoparticles in the photopolymerizable composition.

Optionally, the photopolymerizable composition may contain a monomer that does not include any silica particles, herein referred to as an optional monomer or second monomer. The optional monomer is capable of addition polymerization and is compatible with the binder to the extent that a clear, non-cloudy photosensitive layer is produced. The optional monomer can be a single monomer or mixture of monomers. Monomers are addition-polymerization ethylenically unsaturated compounds with at least one terminal ethylenic group. Monomers that can be used as optional monomer in the photopolymerizable composition are well known in the art and include, but are not limited to, monofunctional acrylates and methacrylates, multifunctional acrylates and methacrylates, polyacryloyl oligomers, and combinations thereof. Generally the monomers have relatively low molecular weights (less than about 30,000). Preferably, the monomers have a relatively low molecular weight less than about 5000. The monomers described above (for the monomer containing silica nanoparticles) are also suitable as the optional monomer. Further examples of monomers can be found in Chen U.S. Patent No. 4,323,636; Fryd et al., U.S. Patent No. 4,753,865; Fryd et al., U.S. Patent No. 4,726,877 and Feinberg et al., U.S. Patent No. 4,894,315. The optional monomer can be present in amounts from 4 to 20% by weight, preferably 5 to 15%, based on the total weight of the photopolymerizable composition.

Additional additives to the photopolymerizable layer include plasticizers, colorants, dyes, processing aids, antioxidants, and antiozonants. Plasticizers, which may sometimes also include monomeric functionality, can include acrylated liquid polyisoprenes, acrylated liquid polybutadienes, liquid polyisoprenes with high vinyl content, and liquid polybutadienes with high vinyl content, (that is, content of 1-2 vinyl groups is greater than 20% by weight). Processing aids may be such things as low molecular weight polymers compatible with the binder. Antiozonants include hydrocarbon waxes, norbornenes, and vegetable oils. Suitable antioxidants include alkylated phenols, alkylated bisphenols, polymerized trimethyldihydroquinone, and dilauryl thiopropinoate.

The thickness of the solid photopolymerizable layer can vary over a wide range depending upon the type of printing form desired, for example, from about 0.015 inch to about 0.250 inch or greater (about 0.038 to about 0.64 cm or greater) with a preferred thickness of about 0.5 mm to 3.9 mm (0.020 to 0.155 inch).

The photosensitive printing element may optionally include a support adjacent the layer of the photopolymerizable composition. The support can be any flexible material that is conventionally used with photosensitive elements used to prepare flexographic printing plates. Preferably the support is transparent to actinic radiation to accommodate "backflash" exposure through the support. Examples of suitable support materials include polymeric films such those formed by addition polymers and linear condensation polymers, transparent foams and fabrics. Under certain end-use conditions, metals such as aluminum, steel, and nickel, may also be used as a support, even though a metal support is not transparent to radiation. A preferred support is a polyester film; particularly preferred is polyethylene terephthalate. The support may be in sheet form or in cylindrical form, such as a sleeve. The sleeve may be formed from single layer or multiple layers of flexible material. Flexible sleeves made of polymeric films are preferred, as they typically are transparent to ultraviolet radiation and thereby accommodate backflash exposure for building a floor in the cylindrical printing element. A suitable sleeve is a multiple layered sleeve as disclosed in U.S. Patent No. 5,301,610. The sleeve may also be made of non-transparent, actinic radiation blocking materials, such as nickel or glass epoxy. The support typically has a thickness from 0.002 to 0.050 inch (0.0051 to 0.127 cm). A preferred thickness for the sheet form is 0.003 to 0.016 inch (0.0076 to 0.040 cm). The sleeve typically has a wall thickness from 10 to 80 mils (0.025 to 0.203 cm) or more. Preferred wall thickness for the cylinder form is 10 to 40 mils (0.025 to 0.10 cm).

Optionally, the element includes an adhesive layer between the support and the photopolymerizable layer, or a surface of the support that is adjacent the photopolymerizable layer has an adhesion-promoting surface. The adhesive layer on the surface of the support can be a subbing layer of an adhesive material or primer or an anchor layer as disclosed in U.S. Patent 2,760,863 to give strong adherence between the support and the photopolymerizable layer. The adhesive compositions disclosed in Burg, U.S. Patent 3,036,913 are also effective. Alternatively, the surface of the support on which the photopolymerizable layer resides can be treated to promote adhesion between the support and the photopolymerizable layer, with flame-treatment or electron-treatment, e.g., corona-treated. Further, the adhesion of the photopolymerizable layer to the support can be adjusted by exposing the element to actinic radiation through the support as disclosed by Feinberg et al. in U.S. Patent 5,292,617.

In one embodiment, the photosensitive printing element includes the support and a layer of the photopolymerizable composition on the support. The composition layer is at least one layer on the substrate capable of being treated. Preferably, the photosensitive element is an elastomeric printing element suitable for use as a flexographic printing form. The at least one layer on the substrate is a photosensitive layer, and most preferably a photopolymerizable layer of an elastomeric composition wherein the photosensitive layer can be selectively cured by actinic radiation.

The photosensitive element may include one or more additional layers on or adjacent the photopolymerizable layer. In most embodiments the one or more additional layers are on a side of the photopolymerizable layer opposite the support. Examples of additional layers include, but are not limited to, a release layer, a capping layer, an elastomeric layer, a laser radiation-sensitive layer, an actinic radiation opaque layer, a barrier layer, and combinations thereof. The one or more additional layers preferably are removable, in whole or in part, during treatment. One or more of the additional layers may cover or only partially cover the photosensitive composition layer. An example of an additional layer which only partially covers the photosensitive composition layer is a masking layer that is formed by imagewise application, e.g., ink jet application, of an actinic radiation blocking material or ink.

The release layer protects the surface of the composition layer and enables the easy removal of a mask used for the imagewise exposure of the photosensitive element. Materials suitable as the release layer are well known in the art. Suitable compositions for the capping layer and methods for forming the layer on the element are disclosed as elastomeric compositions in a multilayer cover element described in Gruetzmacher et al., U.S. Patent Nos. 4,427,759 and 4,460,675. The elastomeric capping layer is similar to the photosensitive layer in that after imagewise exposure the elastomeric capping layer is at least partially removable by treating. The elastomeric capping layer includes an elastomeric binder, which can be the same or different from the elastomeric binder described above, and optionally, one or more monomers, photoinitiator or photoinitiator system, and other additives as described for the photopolymerizable layer. The elastomeric layer or capping layer can be photosensitive itself, that is, contain monomer and initiator, or it can become photosensitive when in contact with the photopolymerizable layer. The composition of the elastomeric capping layer can be the same as, or substantially the same as, or different from the composition of the adjacent photopolymerizable layer. The composition of the elastomeric capping layer may include the monomer containing silica nanoparticles bonded with an organic material capable of crosslinking with the elastomeric binder. The elastomeric capping layer is solid that generally forms a monolithic structure with the adjacent photopolymerizable layer. The thickness of the elastomeric capping layer is typically between about 0.001 inch to about 0.010 inch (0.025 to 0.25 mm).

In one embodiment, the laser radiation sensitive layer is sensitive to infrared laser radiation, and thus may be identified as an infrared-sensitive layer. The laser radiation sensitive layer can be on the photosensitive layer, or on a barrier layer which is on the photosensitive layer, or on a temporary support which together with the photosensitive element form an assemblage. Infrared-sensitive layers and actinic radiation opaque layers are well known in the art. The infrared-sensitive layer can be ablated (i.e., vaporized or removed) from the photosensitive layer on the side opposite the flexible substrate by exposure to infrared laser radiation. Alternatively, when the photosensitive element forms an assemblage with the support carrying the infrared-sensitive layer, the infrared-sensitive layer can be transferred from the temporary support to the external surface (the side opposite the flexible substrate) of the photosensitive layer by exposure to infrared laser radiation. The infrared-sensitive layer can be used alone or with other layers, e.g., ejection layer, heating layer, etc.

The infrared-sensitive layer generally comprises an infrared-absorbing material, a radiation-opaque material, and an optional binder. Dark inorganic pigments, such as carbon black and graphite, generally function as both infrared-sensitive material and radiation-opaque material. The thickness of the infrared-sensitive layer should be in a range to optimize both sensitivity and opacity to actinic radiation (e.g., has an optical density of ≥ 2.5). Such infrared-sensitive photoablative or phototransferable layer can be employed in digital direct-to-plate image technology in which the exposure by laser radiation removes or transfers the infrared-sensitive layer to form an in-situ mask on the photosensitive element. Suitable infrared-sensitive compositions, elements, and their preparation are disclosed in U.S. Patents 5,262,275; US 5,719,009; US 5,607,814; US 5,506,086; US 5,766,819; US 5,840,463; US 5,925,500; US 6,606,410; US 6,238,837; US 6,558,876; and US 6,773,859. The infrared-sensitive layer preferably is removable by contact with an absorbent material in the range of acceptable developing temperatures for the photosensitive element used.

The photosensitive element of the present invention may further include a temporary coversheet on top of the uppermost layer of the photosensitive element. One purpose of the coversheet is to protect the uppermost layer of the photosensitive element during storage and handling. Depending upon end use, the coversheet may or may not be removed prior to imaging, but is removed prior to development. Suitable materials for the coversheet are well known in the art.

The photosensitive composition can be prepared by employing a variety of techniques that are well known in the art. One method which can be used is to mix the components (that is, binder, initiator, monomer with silica particles, and other ingredients) in an extruder and then extrude the mixture as a hot melt onto a support. It is preferred that the extruder be used to perform the functions of melting, mixing, deaerating, and filtering the composition. To achieve uniform thickness, the extrusion step can be advantageously coupled with a calendering step in which the hot mixture is calendered between two sheets or between one flat sheet and a release roll. Alternately, the material can be extruded/calendered onto a temporary support and later laminated to the desired final support. The elements can also be prepared by compounding the components in a suitable mixing device and then pressing the material into the desired shape in a suitable mold. The material is generally pressed between the support and the coversheet. The molding step can involve pressure and/or heat. The coversheet may include one or more of the additional layers which transfer to the photopolymerizable layer when the photosensitive element is formed.

The photosensitive element is prepared for treatment by imagewise exposing the element to actinic radiation. After imagewise exposure, the photosensitive element contains cured portions in the exposed areas of the radiation curable composition layer and uncured portions in the unexposed areas of the radiation curable composition layer. Imagewise exposure is carried out by exposing the photosensitive element through an image-bearing mask. The image-bearing mask may be a black and white transparency or negative containing the subject matter to be printed, or an in-situ mask formed with the laser radiation sensitive layer on the composition layer, or other means known in the art. Imagewise exposure can be carried out in a vacuum (frame) or may be conducted in the presence of atmospheric oxygen. On exposure, the transparent areas of the mask allow addition polymerization or crosslinking to take place, while the actinic radiation opaque areas remain uncrosslinked. Exposure is of sufficient duration to crosslink the exposed areas down to the support or to a back exposed layer (floor). Imagewise exposure time is typically much longer than backflash time, and ranges from a few to tens of minutes.

For direct-to-plate image formation as disclosed in U.S. Patents US 5,262,275; US Patent 5,719,009; US Patent 5,607,814; US Patent 5,506,086; US Patent 5,766,819; US Patent 5,840,463; US 6,238,837; US 6,558,876; and US 6,773,859 the image-bearing mask is formed in-situ with the laser radiation sensitive layer using an infrared laser exposure engine. The imagewise laser exposure can be carried out using various types of infrared lasers, which emit in the range 750 to 20,000 nm, preferably in the range 780 to 2,000 nm. Diode lasers may be used, but Nd:YAG lasers emitting at 1060 nm are preferred.

Actinic radiation sources encompass the ultraviolet, visible and infrared wavelength regions. The suitability of a particular actinic radiation source is governed by the photosensitivity of the initiator and the at least one monomer used in preparing the flexographic printing plates from the photosensitive element. The preferred photosensitivity of most common flexographic printing plates is in the UV and deep visible area of the spectrum, as they afford better room-light stability. The portions of the composition layer that are exposed to radiation chemically cross-link and cure. The portions of the composition layer that are unirradiated (unexposed) are not cured and have a lower melting or liquefying temperature than the cured irradiated portions. The imagewise exposed photosensitive element is then ready for treatment to remove unpolymerized areas in the photopolymerizable layer and thereby form a relief image areas of the image.

An overall back exposure through the support side, a so-called backflash exposure, may be conducted to polymerize a predetermined thickness of the photopolymer layer adjacent the support. The backflash exposure may be conducted before, after, or even during other imaging steps, the imagewise exposure. This polymerized portion of the photopolymer layer is designated a floor. The floor provides improved adhesion between the photopolymerizable layer and the support, helps highlight dot resolution and also establishes the depth of the plate relief. The floor thickness varies with the time of exposure, exposure source, etc. This exposure may be done diffuse or directed. All radiation sources suitable for imagewise exposure may be used. The exposure is generally for 10 seconds to 30 minutes.

Following overall exposure to UV radiation through the mask, the photosensitive printing element is treated to remove unpolymerized areas in the photopolymerizable layer and thereby form a relief image. The treating step removes at least the photopolymerizable layer in the areas which were not exposed to actinic radiation, i.e., the unexposed areas or uncured areas, of the photopolymerizable layer. Except for the elastomeric capping layer, typically the additional layers that may be present on the photopolymerizable layer are removed or substantially removed from the polymerized areas of the photopolymerizable layer. For photosensitive elements in which the mask was formed digitially, the treating step also removes the mask image (which had been exposed to actinic radiation) and the underlying unexposed areas of the photopolymerizable layer.

Treatment of the photosensitive printing element includes (1) "wet" development wherein the photopolymerizable layer is contacted with a suitable developer solution to washout unpolymerized areas and (2) "dry" development wherein the photosensitive element is heated to a development temperature which causes the unpolymerized areas of the photopolymerizable layer to melt or soften or flow and then are removed. Dry development may also be called thermal development. It is also contemplated that combinations of wet and dry treatment can be used to form the relief.

Wet development is usually carried out at about room temperature. The developers can be organic solvents, aqueous or semi-aqueous solutions, and water. The choice of the developer will depend primarily on the chemical nature of the photopolymerizable material to be removed. Suitable organic solvent developers include aromatic or aliphatic hydrocarbon and aliphatic or aromatic halohydrocarbon solvents, or mixtures of such solvents with suitable alcohols. Other organic solvent developers have been disclosed in published German Application 38 28 551. Suitable semi-aqueous developers usually contain water and a water miscible organic solvent and an alkaline material. Suitable aqueous developers usually contain water and an alkaline material. Other suitable aqueous developer combinations are described in U.S. Patent No. 3,796,602.

Development time can vary, but it is preferably in the range of about 2 to about 25 minutes. Developer can be applied in any convenient manner, including immersion, spraying and brush or roller application. Brushing aids can be used to remove the unpolymerized portions of the element. Washout can be carried out in an automatic processing unit which uses developer and mechanical brushing action to remove the uncured portions of the plate, leaving a relief constituting the exposed image and the floor.

Following treatment by developing, in solution, the relief printing plates are generally blotted or wiped dry, and then more fully dried in a forced air or infrared oven. Drying times and temperatures may vary, however, typically the plate is dried for 60 to 120 minutes at 60°C. High temperatures are not recommended because the support can shrink and this can cause registration problems.

Treating the element thermally includes heating the photosensitive element having at least one photopolymerizable layer (and the additional layer/s) to a temperature sufficient to cause the uncured portions of the photopolymerizable layer to liquefy, i.e., soften or melt or flow, and removing the uncured portions. The layer of the photosensitive composition is capable of partially liquefying upon thermal development. That is, during thermal development the uncured composition must soften or melt at a reasonable processing or developing temperature. If the photosensitive element includes one or more additional layers on the photopolymerizable layer, it is preferred that the one or more additional layers are also removable in the range of acceptable developing temperatures for the photopolymerizable layer. The polymerized areas (cured portions) of the photopolymerizable layer have a higher melting temperature than the unpolymerized areas (uncured portions) and therefore do not melt, soften, or flow at the thermal development temperatures. The uncured portions can be removed from the cured portions of the composition layer by any means including air or liquid stream under pressure as described in U.S. publication 2004/0048199 A1, vacuum as described in Japanese publication 53-008655, and contacting with an absorbent material as described in U.S. 3,060,023; U.S. 3,264,103; U.S. 5,015,556; U.S. 5,175,072; U.S. 5,215,859; U.S. Patent 5,279,697; and U.S. 6,797,454. A preferred method for removing the uncured portions is by contacting an outermost surface of the element to an absorbent surface, such as a development medium, to absorb or wick away or blot the melt portions.

The term "melt" is used to describe the behavior of the unirradiated (uncured) portions of the composition layer subjected to an elevated temperature that softens and reduces the viscosity to permit absorption by the absorbent material. The material of the meltable portion of the composition layer is usually a viscoelastic material which does not have a sharp transition between a solid and a liquid, so the process functions to absorb the heated composition layer at any temperature above some threshold for absorption in the development medium. Thus, the unirradiated portions of the composition layer soften or liquefy when subjected to an elevated temperature: However throughout this specification the terms "melting", "softening", and "liquefying" may be used to describe the behavior of the heated unirradiated portions of the composition layer, regardless of whether the composition may or may not have a sharp transition temperature between a solid and a liquid state. A wide temperature range may be utilized to "melt" the composition layer for the purposes of this invention. Absorption may be slower at lower temperatures and faster at higher temperatures during successful operation of the process.

The thermal treating steps of heating the photosensitive element and contacting an outermost surface of the element with development medium can be done at the same time, or in sequence provided that the uncured portions of the photopolymerizable layer are still soft or in a melt state when contacted with the development medium. The at least one photopolymerizable layer (and the additional layer/s) are heated by conduction, convection, radiation, or other heating methods to a temperature sufficient to effect melting of the uncured portions but not so high as to effect distortion of the cured portions of the layer. The one or more additional layers disposed above the photopolymerizable layer may soften or melt or flow and be absorbed as well by the development medium. The photosensitive element is heated to a surface temperature above about 40°C, preferably from about 40°C to about 230°C (104-446°F) in order to effect melting or flowing of the uncured portions of the photopolymerizable layer. By maintaining more or less intimate contact of the development medium with the photopolymerizable layer that is molten in the uncured regions, a transfer of the uncured photosensitive material from the photopolymerizable layer to the development medium takes place. While still in the heated condition, the development medium is separated from the cured photopolymerizable layer in contact with the support layer to reveal the relief structure. A cycle of the steps of heating the photopolymerizable layer and contacting the molten (portions) layer with the development medium can be repeated as many times as necessary to adequately remove the uncured material and create sufficient relief depth. However, it is desirable to minimize the number of cycles for suitable system performance, and typically the photopolymerizable element is thermally treated for 5 to 15 cycles. Intimate contact of the development medium to the photopolymerizable layer (while in the uncured portions are melt) may be maintained by the pressing the layer and the development medium together.

Apparatuses suitable for thermally developing the photosensitive element are disclosed by Peterson et al. in U.S. Patent 5,279,697, and also by Johnson et al. in U.S. Patent 6,797,454. The photosensitive element in all embodiments is in the form of a plate. However, it should be understood that one of ordinary skill in the art could modify each of the disclosed apparatuses to accommodate the mounting of the photosensitive element in the form of a cylinder or a sleeve.

The development medium is selected to have a melt temperature exceeding the melt or softening or liquefying temperature of the unirradiated or uncured portions of the radiation curable composition and having good tear resistance at the same operating temperatures. Preferably, the selected material withstands temperatures required to process the photosensitive element during heating. The development medium may also be referred to herein as development material, absorbent material, absorbent web, and web. The development medium is selected from non-woven materials, paper stocks, fibrous woven material, open-celled foam materials, porous materials that contain more or less a substantial fraction of their included volume as void volume. The development medium can be in web or sheet form. The development medium should also possess a high absorbency for the molten elastomeric composition as measured by milligrams of elastomeric composition that can be absorbed per square centimeter of the development medium. It is also desirable that fibers are bonded in development mediums containing fibers so that the fibers are not deposited into the form during development. Non-woven nylon and polyester webs are preferred.

After the treatment step, the photosensitive element can be uniformly post-exposed to ensure that the photopolymerization process is complete and that the so formed flexographic printing plate will remain stable during printing and storage. This post-exposure step can utilize the same radiation source as the imagewise main exposure. Furthermore, if the surface of the flexographic printing plate is still tacky, detackification treatments may be applied. Such methods, which are also called "finishing", are well known in the art. For example, tackiness can be eliminated by a treatment of the flexographic printing plate with bromine or chlorine solutions. Preferably, detackification is accomplished by exposure to UV radiation sources having a wavelength not longer than 300 nm. This so-called "light-finishing" is disclosed in European Published Patent Application 0 017927 and U.S. Patent No. 4,806,506. Various finishing methods may also be combined. Typically, the post-exposure and the finishing exposure are done at the same time on the photosensitive element using an exposure device that has both sources of radiation.

### EXAMPLES

Unless otherwise indicated in the following examples, a photopolymerizable composition was prepared and formed into a layer by a two-roll mill between a support film and a coversheet film forming a printing element. The support and coversheet were each a 5 mil thick MYLAR® polyethylene terephthalate film (PET). The printing element was 67 mil thick (photopolymerizable layer and support). In each example, two printing elements having the same photopolymerizable composition were prepared. The elements were then exposed on a CYREL® exposure unit to ultraviolet radiation at 365nm for a overall exposure through the support for 20 seconds and for imagewise exposure through a photomask under vacuum for 12 minutes. The photomask used in the imagewise exposure was the same for all elements, and included line work and a screen area having at least a 20% dots.

One of the exposed elements was then processed in a CYREL® *FAST* TD1000 processor, at the conditions recommended for 67 mil plates, to form a relief surface suitable for flexographic printing. The *FAST* TD1000 processor included infrared lamps to aid in heating the printing element. Each plate was measured after each pass in the *FAST* processor to determine depth of relief obtained. A pass of the printing element in the thermal processor constituted heating the element, contacting the element with a web of a nonwoven development medium to remove unpolymerized portions, and separating the development medium from the element. The number of passes that the printing plate made to reach the relief depth of 22 to 25 mils was recorded.

The other exposed element was then processed in a CYREL® 2001 inline processor with brushing action to remove softened unpolymerized areas, at the conditions recommended for 67 mil plates, using OPTISOL® solvent developing solution, and dried at 60°C for 2 hours. The solvent processed plate was then tested on a Linear Abraser 5700 device (an abrasion testing device from Taber Industries) to determine mechanical strength and wear resistance. The device included a tip that was moved over a top surface of the 20% dot area under a load of 1 kg at a speed of 30 cycles/minute for about 1 minute. The plates were analyzed under a microscope (10X magnification) and the number of missing dots from an area of 5 inch by 5 inch was recorded. This area represented approximately 25 dots.

The plates were then blanket exposed to ultraviolet radiation at 254nm for 5 minutes to detackify the plate surface.

In the following examples, all percentages are based on weight, unless otherwise indicated. CYREL® exposure unit, CYREL® *FAST* TD1000 processor, CYREL® OPTISOL® developing solution are all available from The DuPont Company (Wilmington, DE).

### Example 1

The photopolymerizable composition included 55% of a styrenebutadiene-styrene (SBS) block copolymer, type KX405 from Kraton Polymers; 10% of a plasticizer, Nisso PB1000 polybutadiene oil, from Nippon Soda; and 35% of a monomer mixture. The monomer mixture included 30% of hexamethylene diacrylate (HMDA) from Sartomer, 3% of a photoinitiator, a benzyl dimethyl-ketal (BDK) from Lamberti; 1.9% of a thermal stabilizer, a butylated hydroxytoluene (BHT); and 0.1 % of a red dye solution (all weight % of the components in the monomer mixture are based on the total weight of the photopolymerizable composition).

The photopolymerizable composition was prepared and milled forming two printing elements, and then exposed and processed as described above.

### Example 2

A photopolymerizable composition was prepared the same as that described in Example 1 except that the monomer mixture included 28% HMDA; 2% Nanocryl® 140 functionalized silica nanoparticles from Hanse Chemie; and the remainder of ingredients were the same as described above. The functionalized silica nanoparticles were dispersed in hexamethylene diacrylate at 50% loading, and had an average particle size of 20 nm. The concentration of the functionalized silica particles was 1% of the total photopolymerizable composition, i.e., 1% loading. The silica particles were functionalized by including a reactive organic compound on an outer surface of the particles that crosslinks during photopolymerization.

The photopolymerizable composition was prepared and milled forming two printing elements, and then exposed and processed as described above.

### Example 3

A photopolymerizable composition was prepared the same as that described in Example 1 except that the monomer mixture included 14% HMDA; 16% Nanocryl® 140 silica particles; and the remainder of the ingredients were the same. The concentration of the silica particles was 8% in the photopolymerizable composition.

The photopolymerizable composition was prepared and milled forming two printing elements, and then exposed and processed as described above.

### Example 4

A photopolymerizable composition was prepared the same as that described in Example 1 except that the monomer mixture included 22% of HMDA; 8% of Aerosil A200 fumed silica nanoparticles having a average particle size of 50nm from Degussa; and the remainder of the ingredients were the same. Prior to adding the fumed silica to the mixture, the silica particles were dried in an over at 120°C for 48 hours. The fumed silica particles were then vigorously stirred in the monomer mixture.

The photopolymerizable composition was prepared and milled forming two printing elements, and then exposed and processed as described above.

### Example 5

A photopolymerizable composition was prepared the same as that described in Example 1 except that the monomer mixture included 30% of the Nanocryl® functionalized silica nanoparticles dispersed in HMDA; and the remainder of the ingredients were the same (no additional HMDA monomer was included). The final concentration of the silica particles was 15% of the photopolymerizable composition.

The photopolymerizable composition was prepared and milled forming two printing elements, and then exposed and processed as described above.

The number of passes to reach the desired relief for each plate that was thermally processed was recorded in the following Table. Also recorded in the Table was the number of dots missing in the 20% dot area from the Taber Abrasion Test for the solvent processed plates.

| | Example 1 | Example 2 | Example 3 | Example 4 | Example 5 |
|---|---|---|---|---|---|
| | Control | 1% load | 8% load | Comparative 8 | 15% load |
| Number of thermal passes to form relief | 11 | 11 | 8 | 8 | 4 |
| Number of dots missing abrasion test | 18 | 16 | 3 | 10 | none |

The results showed that printing forms containing the functionalized silica nanoparticles provided a significant improvement in mechanical strength to resist wear, i.e., dot chipping and holding fine lines, compared to printing forms having no silica or fumed (and nonfunctionalized) silica nanoparticles. The more dots missing the less resistant to wear the plate. As little as 1 % loading of the functionalized silica particles in the photopolymerizable layer improved wear resistance for the printing form. At 8% loading of the silica particles in the photopolymer layer, the plate containing the functionalized silica had only 2 dots missing whereas the plate containing the fumed silica had 10 dots missing. It is believed that this improvement in wear resistance is because the functionalized silica particles participate directly in the body of the polymerization network via the functionalized organic groups, e.g., vinyl groups, on the surface of the nanoparticles and the covalent bonds from the acrylate monomer and/or from the butadiene midblock in the block copolymer. The presence of the fumed silica in the photopolymer layer act only as reinforcers by filling the voids in the crosslinked polymer, and do not participate in the polymerization network.

Also, printing forms containing the functionalized silica nanoparticles provided a significant improvement in reducing the passes or cycles necessary to form the desired relief surface by thermal development. At 15% loading of the functionalized silica particles in the photopolymer layer reduced the number of cycles by about a third compared to printing forms having no silica.

Furthermore when compared to the control plates, the plates containing silica, functionalized or fumed, reached desired relief depth in fewer passes indicating that more polymer is melted and removed on each pass because the silica absorbs more energy from the infrared heating lamps present in the thermal processor.

## Claims

1. A photosensitive printing element comprising:
a layer of a photopolymerizable composition comprising an elastomeric binder, a photoinitiator, and a monomer comprising silica particles bonded with an organic material capable of crosslinking with the elastomeric binder.

2. The photosensitive printing element of Claim 1 wherein the monomer is selected from the group consisting of acrylates, methacrylates, and combinations thereof.

3. The photosensitive printing element of Claim 1 or Claim 2 wherein the monomer is selected from the group consisting of acrylate monoesters of alcohols and polyols; acrylate polyesters of alcohols and polyols; methacrylate monoesters of alcohols and polyols; methacrylate polyesters of alcohols and polyols; and acrylate and methacrylate derivatives of isocyanates, acrylate and methacrylate derivatives of esters, acrylate and methacrylate derivatives of epoxides; and combinations thereof.

4. The photosensitive printing element of any one of Claims 1 to 3 wherein the monomer is selected from the group consisting of hexanediol diacrylate; hexanediol dimethacrylate; ethylene glycol diacrylate; ethylene glycol dimethacrylate; diethylene glycol diacrylate; and trimethylol propane triacrylate.

5. The photosensitive printing element of any one of Claims 1 to 4 wherein the silica particles have a diameter between 5 and 50 nanometers.

6. The photosensitive printing element of any one of Claims 1 to 5 wherein the silica particles have a diameter between 5 and 40 nanometers.

7. The photosensitive printing element of any one of Claims 1 to 6 wherein the silica particles have a diameter between 18 and 22 nanometers.

8. The photosensitive printing element of any one of Claims 1 to 7 wherein the amount of the silica particles is between 10 and 80% by weight, based on the total weight of the monomer and silica particles.

9. The photosensitive printing element of any one of Claims 1 to 8 wherein the amount of the silica particles is between 30 and 60% by weight, based on the total weight of the monomer and silica particles.

10. The photosensitive printing element of any one of Claims 1 to 9 wherein the amount of monomer comprising silica particles is between 1 to 50% by weight, based on the total weight of the photopolymerizable composition.

11. The photosensitive printing element of any one of Claims 1 to 10 wherein the amount of monomer comprising silica particles is between 3 to 30% by weight, based on the total weight of the photopolymerizable composition.

12. The photosensitive printing element of any one of Claims 1 to 9 wherein the amount of silica particles is between 0.1 to 30% by weight, based on the total weight of the photopolymerizable composition.

13. The photosensitive printing element of any one of Claims 1 to 9 or Claim 12 wherein the amount of silica particles is between 5 to 20% by weight, based on the total weight of the photopolymerizable composition.

14. The photosensitive printing element of any one of Claims 1 to 13 wherein the silica particles are suspended homogeneously in the monomer.

15. The photosensitive printing element of any one of Claims 1 to 3 wherein the monomer comprising silica particles is selected from the group consisting of hydroxyethylmethacrylate and contains 50% by weight of the silica particles; hexanedioldiacrylate and contains 50% by weight of the silica particles; and trimethylolpropanetriacrylate and contains 50% by weight of the silica particles, based on the total weight of the monomer and silica.

16. The photosensitive printing element of any one of Claims 1 to 15 wherein the photopolymerizable composition further comprises at least one optional monomer.

17. The photosensitive printing element of Claim 16 wherein the amount of the at least one optional monomer is between 4 to 20% by weight, based on the total weight of the photopolymerizable composition.

18. The photosensitive printing element of any one of Claims 1 to 17 wherein the elastomeric binder is an A-B-A type block copolymer, where A represents a nonelastomeric block, and B represents an elastomeric block.

19. The photosensitive printing element of Claim 18 wherein the A is a vinyl polymer and the B is polybutadiene or polyisoprene.

20. The photosensitive printing element of any one of Claims 1 to 19 wherein the elastomeric binder is selected from the group consisting of poly(styrene/isoprene/styrene) block copolymers, poly(styrene/butadiene/styrene) block copolymers, and combinations of poly(styrene/isoprene/styrene) block copolymers and poly(styrene/butadiene/styrene) block copolymers.

21. The photosensitive printing element of any one of Claims 1 to 20 further comprising a support adjacent the layer of photopolymerizable composition.

22. The photosensitive printing element of any one of Claims 1 to 21 further comprising at least one additional layer disposed above the photopolymerizable layer, wherein the at least one additional layer is selected from the group consisting of a release layer, an elastomeric layer, a barrier layer, a wax layer, a digital recording layer.

23. The photosensitive printing element of Claim 22 wherein the digital recording layer is sensitive to infrared laser radiation.

24. The photosensitive printing element of Claim 22 or Claim 23 further comprising the elastomeric layer on the photopolymerizable layer, an elastomeric layer comprising an elastomeric binder and a monomer comprising silica particles bonded with an organic material capable of crosslinking with the elastomeric binder.

25. The photosensitive printing element of Claim 24 wherein the monomer with silica particles in the elastomeric layer can be the same or different from the monomer with silica particles in the photopolymerizable layer.

26. The photosensitive printing element of any one of Claims 1 to 25 wherein the layer of the photopolymerizable composition has a thickness of 0.038 to 0.635 cm (0.015 to 0.250 inch).

27. The photosensitive printing element of any one of Claims 1 to 26 wherein the layer of the photopolymerizable composition is solid.

28. A process for preparing a flexographic printing form comprising:
a) providing a photosensitive printing element comprising a layer of a photopolymerizable composition comprising an elastomeric binder,a photoinitiator, and a monomer comprising silica particles bonded with an organic material capable of crosslinking with the elastomeric binder;
b) imagewise exposing the photopolymerizable layer to actinic radiation forming polymerized portions and unpolymerized portions in the layer; and
c) treating the element of b) to remove the unpolymerized portions and form a relief surface suitable for printing.

29. The process of Claim 28 wherein the treating step (c) is selected from the group consisting of
(a) processing with at least one washout solution selected from the group consisting of solvent solution, aqueous solution, semi-aqueous solution, and water; and
(b) heating the element to a temperature sufficient to cause the unpolymerized portions to melt, flow, or soften, and removing the unpolymerized portions.

30. The process of Claim 28 wherein the treating step comprises heating the element to a temperature sufficient to cause the unpolymerized portions to melt, flow, or soften and removing the unpolymerized portions by contacting the element with a development medium.

31. The process of Claim 29 wherein the heating step is selected from the group consisting of conduction, convection, radiation, and combinations thereof.

32. A flexographic printing form made according to the process of Claim 28.

## Patentansprüche

1. Lichtempfindliches Druckelement umfassend:
eine Schicht einer lichtempfindlichen Zusammensetzung umfassend ein elastomeres Bindemittel, einen Photoinitiator und ein Monomer umfassend Siliciumdioxidteilchen, die mit einem organischen Material bondiert sind, das des Vernetzens mit dem elastomeren Bindemittel fähig ist.

2. Lichtempfindliches Druckelement nach Anspruch 1, wobei das Monomer aus der Gruppe ausgewählt ist bestehend aus Acrylaten, Methacrylaten und Kombinationen davon.

3. Lichtempfindliches Druckelement nach Anspruch 1 oder Anspruch 2, wobei das Monomer aus der Gruppe ausgewählt ist bestehend aus Acrylatmonoestern von Alkoholen und Polyolen; Acrylatpolyestern von Alkoholen und Polyolen; Methacrylatmonoestem von Alkoholen und Polyolen; Methacrylatpolyestern von Alkoholen und Polyolen; und Acrylat- und Methacrylatderivaten von Isocyanaten, Acrylat- und Methacylatderivaten von Estern, Acrylat- und Methacrylatderivaten von Epoxiden; und Kombinationen davon.

4. Lichtempfindliches Druckelement nach einem der Ansprüche 1 bis 3, wobei das Monomer aus der Gruppe ausgewählt ist bestehend aus Hexandioldiacrylat; Hexandioldimethacrylat; Ethylenglykoldiacrylat; Ethylenglykoldimethacrylat; Diethylenglykoldiacrylat und Trimethylolpropantriacrylat.

5. Lichtempfindliches Druckelement nach einem der Ansprüche 1 bis 4, wobei die Siliciumdioxidteilchen einen Durchmesser zwischen 5 und 50 Nanometern ausweisen.

6. Lichtempfindliches Druckelement nach einem der Ansprüche 1 bis 5, wobei die Siliciumdioxidteilchen einen Durchmesser zwischen 5 und 40 Nanometern ausweisen.

7. Lichtempfindliches Druckelement nach einem der Ansprüche 1 bis 6, wobei die Siliciumdioxidteilchen einen Durchmesser zwischen 18 und 22 Nanometern ausweisen.

8. Lichtempfindliches Druckelement nach einem der Ansprüche 1 bis 7, wobei die Menge der Siliciumdioxidteilchen zwischen 10 und 80 Gew.-%, auf das Gesamtgewicht der Monomer- und Siliciumdioxidteilchen bezogen, beträgt.

9. Lichtempfindliches Druckelement nach einem der Ansprüche 1 bis 8, wobei die Menge der Siliciumdioxidteilchen zwischen 30 und 60 Gew.-%, auf das Gesamtgewicht der Monomer- und Siliciumdioxidteilchen bezogen, beträgt.

10. Lichtempfindliches Druckelement nach einem der Ansprüche 1 bis 9, wobei die Menge des Monomers, das Siliciumdioxidteilchen umfasst, zwischen 1 und 50 Gew.-%, auf das Gesamtgewicht der photopolymerisierbaren Zusammensetzung bezogen, beträgt.

11. Lichtempfindliches Druckelement nach einem der Ansprüche 1 bis 10, wobei die Menge des Monomers, das Siliciumdioxidteilchen umfasst, zwischen 3 und 30 Gew.-%, auf das Gesamtgewicht der photopolymerisierbaren Zusammensetzung bezogen, beträgt.

12. Lichtempfindliches Druckelement nach einem der Ansprüche 1 bis 9, wobei die Menge an Siliciumdioxidteilchen zwischen 0,3 und 30 Gew.-%, auf das Gesamtgewicht der photopolymerisierbaren Zusammensetzung bezogen, beträgt.

13. Lichtempfindliches Druckelement nach einem der Ansprüche 1 bis 9 oder Anspruch 12, wobei die Menge an Siliciumdioxidteilchen zwischen 5 und 20 Gew.-%, auf das Gesamtgewicht der photopolymerisierbaren Zusammensetzung bezogen, beträgt.

14. Lichtempfindliches Druckelement nach einem der Ansprüche 1 bis 13, wobei die Siliciumdioxidteilchen homogen in dem Monomer suspendiert sind.

15. Lichtempfindliches Druckelement nach einem der Ansprüche 1 bis 3, wobei das Monomer, das Siliciumdioxidteilchen umfasst, aus der Gruppe ausgewählt ist, die aus Hydroxyethylmethacrylat besteht, und 50 Gew.-% der Siliciumdioxidteilchen enthält; die aus Hexandiolacrylat besteht, und 50 Gew.-% der Siliciumdioxidteilchen enthält; die aus Trimethylolpropantriacrylat besteht, und 50 Gew.-% der Siliciumdioxidteilchen enthält, auf das Gesamtgewicht des Monomers und Siliciumdioxids bezogen.

16. Lichtempfindliches Druckelement nach einem der Ansprüche 1 bis 15, wobei die photopolymerisierbare Zusammensetzung des Weiteren mindestens ein wahlweises Monomer umfasst.

17. Lichtempfindliches Druckelement nach Anspruch 16, wobei die Menge des mindestens einen wahlweisen Monomers zwischen 4 und 20 Gew.-%, auf das Gesamtgewicht der photopolymerisierbaren Zusammensetzung bezogen, liegt.

18. Lichtempfindliches Druckelement nach einem der Ansprüche 1 bis 17, wobei das elastomere Bindemittel ein Blockcopolymer vom A-B-A-Typ ist, wobei A einen nichtelastomeren Block und B einen elastomeren Block darstellt.

19. Lichtempfindliches Druckelement nach Anspruch 18, wobei das A ein Vinylpolymer und das B Polybutadien oder Polyisopren ist.

20. Lichtempfindliches Druckelement nach einem der Ansprüche 1 bis 19, wobei das elastomere Bindmittel aus der Gruppe ausgewählt ist bestehend aus Poly(styrol-Isopren-Styrol-) Blockcopolymeren, Poly(styrol-Butadien-Styrol-) Blockcopolymeren und Kombinationen von Poly(styrol-Isopren-Styrol-) Blockcopolymeren und Poly(styrolButadien-Styrol-) Blockcopolymeren.

21. Lichtempfindliches Druckelement nach einem der Ansprüche 1 bis 20, des Weiteren einen Träger an der Schicht photopolymerisierbarer Zusammensetzung anliegend umfassend.

22. Lichtempfindliches Druckelement nach einem der Ansprüche 1 bis 21, des weiteren mindestens eine zusätzliche Schicht umfassend, die sich über der photopolymerisierbaren Schicht befindet, wobei die mindestens eine zusätzliche Schicht aus der Gruppe ausgewählt ist bestehend aus einer Trennschicht, einer elastomeren Schicht, einer Barriereschicht, einer Wachsschicht und einer digitalen Aufnahmeschicht.

23. Lichtempfindliches Druckelement nach Anspruch 22, wobei die digitale Aufnahmeschicht für Infrarotlaserstrahlung empfindlich ist.

24. Lichtempfindliches Druckelement nach Anspruch 22 oder 23, des Weiteren die elastomere Schicht auf der photopolymerisierbaren Schicht, eine elastomere Schicht, die ein elastomeres Bindemittel umfasst, und ein Monomer, das Siliciumdioxidteilchen umfasst, die mit einem organischen Material bondiert sind, das des Vernetzens mit dem elastomeren Bindemittel fähig ist, umfassend

25. Lichtempfindliches Druckelement nach Anspruch 24, wobei das Monomer mit Siliciumdioxidteilchen in der elastomeren Schicht gleich wie oder verschieden von dem Monomer mit Siliciumdioxidteilchen in der photopolymerisierbaren Schicht sein kann.

26. Lichtempfindliches Druckelement nach einem der Ansprüche 1 bis 25, wobei die Schicht der photopolymerisierbaren Zusammensetzung eine Dicke von 0,038 bis 0,635 cm (0,015 bis 0,250 Zoll) aufweist.

27. Lichtempfindliches Druckelement nach einem der Ansprüche 1 bis 26, wobei die Schicht der photopolymerisierbaren Zusammensetzung fest ist.

28. Verfahren zum Herstellen einer flexographischen Druckform, umfassend:
a) das Bereitstellen eines photoempfindlichen Druckelements umfassend eine Schicht einer photopolymerisierbaren Zusammensetzung umfassend ein elastomeres Bindemittel, einen Photoinitiator und ein Monomer umfassend Siliciumdioxidteilchen, die mit einem organischen Material bondiert sind, das des Vernetzen mit dem elastomeren Bindemittel fähig ist;
b) das bildweise Aussetzen der photopolymerisierbaren Schicht aktinischer Strahlung gegenüber unter Bildung polymerisierter Anteile und unpolymerisierter Anteile in der Schicht; und
c) das Behandeln des Elements b), um die unpolymerisierten Anteile zu entfernen und eine Relieffläche zu bilden, die für das Drucken geeignet ist.

29. Verfahren nach Anspruch 28, wobei der Behandlungsschritt (c) aus der Gruppe ausgewählt ist bestehend aus
(a) dem Verarbeiten mit mindestens einer Auswaschlösung ausgewählt aus der Gruppe bestehend aus Lösungsmittellösung, wässriger Lösung, halbwässriger Lösung und Wasser; und
(b) dem Erhitzen des Elements auf eine Temperatur, die ausreicht, um zu verursachen, dass die unpolymerisierten Anteile schmelzen, fließen oder sich erweichen, und dem Entfernen der unpolymerisierten Anteile.

30. Verfahren nach Anspruch 28, wobei der Behandlungsschritt das Erhitzen des Elements auf eine Temperatur, die ausreicht, um zu verursachen, dass die unpolymerisierten Anteile schmelzen, fließen oder sich erweichen, und das Entfernen der unpolymerisierten Anteile durch Kontaktieren des Elements mit einem Entwicklungsmedium umfasst.

31. Verfahren nach Anspruch 29, wobei der Erhitzungsschritt aus der Gruppe ausgewählt ist bestehend aus Konduktion, Konvektion, Strahlung und Kombinationen davon.

32. Flexographische Druckform, die nach dem Verfahren nach Anspruch 28 hergestellt wird.

## Revendications

1. Élément d'impression photosensible comprenant:
une couche d'une composition photopolymérisable comprenant un liant élastomère, un photo-initiateur et un monomère comprenant des particules de silice liées à un matériau organique capable de réticulation avec le liant élastomère.

2. Élément d'impression photosensible selon la revendication 1, le monomère étant choisi parmi le groupe constitué des acrylates, des méthacrylates, et de leurs combinaisons.

3. Élément d'impression photosensible selon la revendication 1 ou selon la revendication 2, le monomère étant choisi parmi le groupe constitué des monoesters d'acrylate d'alcools de polyol; des polyesters acrylate d'alcools et de polyols; des monoesters méthacrylate d'alcools et de polyols; des méthacrylate polyesters d'alcools et de polyols; et des dérivés acrylate et méthacrylate d'isocyanates, des dérivés acrylate et méthacrylate d'esters, des dérivés acrylate et méthacrylate d'époxydes; et de leurs combinaisons.

4. Élément d'impression photosensible selon l'une quelconque des revendications 1 à 3, le monomère étant choisi parmi le groupe constitué du diacrylate d'hexanediol; du diméthacrylate d'hexanediol; du diacrylate d'éthylène glycol; du diméthacrylate d'éthylène glycol; du diacrylate de diéthylène glycol; et du triacrylate de triméthylol propane.

5. Élément d'impression photosensible selon l'une quelconque des revendications 1 à 4, les particules de silice ayant un diamètre compris entre 5 et 50 nanomètres.

6. Élément d'impression photosensible selon l'une quelconque des revendications 1 à 5, les particules de silice ayant un diamètre compris entre 5 et 40 nanomètres.

7. Élément d'impression photosensible selon l'une quelconque des revendications 1 à 6, les particules de silice ayant un diamètre compris entre 18 et 22 nanomètres.

8. Élément d'impression photosensible selon l'une quelconque des revendications 1 à 7, la quantité de particules de silice étant comprise entre 10 et 80 % en poids, sur la base du poids total du monomère et des particules de silice.

9. Élément d'impression photosensible selon l'une quelconque des revendications 1 à 8, la quantité de particules de silice étant comprise entre 30 et 60 % en poids, sur la base du poids total du monomère et des particules de silice.

10. Élément d'impression photosensible selon l'une quelconque des revendications 1 à 9, la quantité de monomère comprenant des particules de silice étant comprise entre 1 à 50 % en poids, sur la base du poids total de la composition photopolymérisable.

11. Élément d'impression photosensible selon l'une quelconque des revendications 1 à 10, la quantité de monomère comprenant des particules de silice étant comprise entre 3 à 30 % en poids, basée sur le poids total de la composition photopolymérisable.

12. Élément d'impression photosensible selon l'une quelconque des revendications 1 à 9, la quantité de particules de silice étant comprise entre 0,1 à 30 % en poids, basée sur le poids total de la composition photopolymérisable.

13. Élément d'impression photosensible selon l'une quelconque des revendications 1 à 9 ou revendication 12, la quantité de particules de silice étant comprise entre 5 à 20 % en poids, basée sur le poids total de la composition photopolymérisable.

14. Élément d'impression photosensible selon l'une quelconque des revendications 1 à 13, les particules de silice étant mises en suspension de manière homogène dans le monomère.

15. Élément d'impression photosensible selon l'une quelconque des revendications 1 à 3, le monomère comprenant les particules de silice étant choisi parmi le groupe constitué du méthacrylate d'hydroxyéthyle et contenant 50 % en poids de particules de silice; de diacrylate d'hexanediol et contenant 50 % en poids de particules de silice; et de triacrylate de triméthylolpropane et contenant 50 % en poids de particules de silice, sur la base du poids total du monomère et de la silice.

16. Élément d'impression photosensible selon l'une quelconque des revendications 1 à 15, la composition photopolymérisable comprenant en outre au moins un monomère facultatif.

17. Élément d'impression photosensible selon la revendication 16, la quantité du au moins un monomère facultatif étant comprise entre 4 à 20 % en poids, basée sur le poids total de la composition photopolymérisable.

18. Élément d'impression photosensible selon l'une quelconque des revendications 1 à 17, le liant élastomère étant un copolymère séquencé de type A-B-A, où A représente un bloc non élastomère, et B représente un bloc élastomère.

19. Élément d'impression photosensible selon la revendication 18, le A étant un polymère vinylique et le B étant du polybutadiène ou du polyisoprène.

20. Élément d'impression photosensible selon l'une quelconque des revendications 1 à 19, le liant élastomère étant choisi parmi le groupe constitué des copolymères séquencés de poly(styrène/isoprène/styrène), des copolymères séquencés de poly(styrène/butadiène/styrène), et des combinaisons des copolymères séquencés de poly(styrène/isoprène/styrène) et des copolymères séquencés de poly(styrène/butadiène/styrène).

21. Élément d'impression photosensible selon l'une quelconque des revendications 1 à 20, comprenant en outre un support adjacent à la couche de composition photopolymérisable.

22. Élément d'impression photosensible selon l'une quelconque des revendications 1 à 21, comprenant en outre au moins une couche supplémentaire disposée au-dessus de la couche photopolymérisable, la au moins une couche supplémentaire étant choisie parmi le groupe constitué d'une couche de démoulage, d'une couche élastomère, d'une couche formant barrière, d'une couche de cire, et d'une couche d'enregistrement numérique.

23. Élément d'impression photosensible selon la revendication 22, la couche d'enregistrement numérique étant sensible à l'irradiation par laser infrarouge.

24. Élément d'impression photosensible selon la revendication 22 ou la revendication 23, comprenant en outre la couche élastomère sur la couche photopolymérisable, une couche élastomère comprenant un liant élastomère et un monomère comprenant des particules de silice liées à un matériau organique capable de réticulation avec le liant élastomère.

25. Élément d'impression photosensible selon la revendication 24, lé monomère avec les particules de silice dans la couche élastomère pouvant être identique ou différent du monomère avec les particules de silice dans la couche photopolymérisable.

26. Élément d'impression photosensible selon l'une quelconque des revendications 1 à 25, la couche de la composition photopolymérisable ayant une épaisseur de 0,038 à 0,635 cm (0,015 à 0,250 pouce).

27. Élément d'impression photosensible selon l'une quelconque des revendications 1 à 26, la couche de composition photopolymérisable étant solide.

28. Procédé de préparation d'une forme d'impression flexographique comprenant:
a) la fourniture d'un élément d'impression photosensible comprenant une couche d'une composition photopolymérisable comprenant un liant élastomère, un photo-initiateur, et un monomère comprenant des particules de silice liées à un matériau organique capable de réticulation avec le liant élastomère;
b) l'exposition à la manière d'une image de la couche photopolymérisable à une irradiation actinique formant des portions polymérisées et des portions non polymérisées dans la couche; et
c) le traitement de l'élément de b) pour retirer les portions non polymérisées et former une surface en relief convenant à l'impression.

29. Procédé selon la revendication 28, l'étape (c) de traitement étant choisie parmi le groupe constitué de
(a) le traitement avec au moins une solution de lavage choisie parmi le groupe constitué de la solution de solvant, de la solution aqueuse, de la solution semi-aqueuse et de l'eau; et
(b) le chauffage de l'élément à une température suffisante pour entraîner la fusion, l'écoulement ou le ramollissement des portions non polymérisées, et l'élimination des portions non polymérisées.

30. Procédé selon la revendication 28, l'étape de traitement comprenant le chauffage de l'élément à une température suffisante pour provoquer la fusion, l'écoulement ou le ramollissement des portions non polymérisées et l'élimination des portions non polymérisées par mise en contact de l'élément avec un milieu de développement.

31. Procédé selon la revendication 29, l'étape de chauffage étant choisie parmi le groupe constitué de la conduction, de la convection, de l'irradiation, et de leurs combinaisons.

32. Forme d'impression flexographique fabriquée selon le procédé selon la revendication 28.
